# EUROPEAN PATENT SPECIFICATION

(11) **EP 4 535 358 B1**
(45) Date of publication and mention of the grant of the patent: **28.10.2026**
(21) Application number: 24200308.5
(22) Date of filing: 13.09.2024
(51) Int. Cl.: G11C 8/08

(54) **ROW DECODER CIRCUIT AND CORRESPONDING METHOD OF OPERATION**
ZEILENDEKODIERSCHALTUNG UND ENTSPRECHENDES BETRIEBSVERFAHREN
CIRCUIT DÉCODEUR DE RANGÉE ET PROCÉDÉ DE FONCTIONNEMENT CORRESPONDANT

(30) Priority: 03.10.2023 IT 202300020436
(43) Date of publication of application: 09.04.2025
(73) Proprietor: STMicroelectronics International N.V., 1228 Plan-les-Ouates, Geneva (CH)
(72) Inventor: DISEGNI, Fabio Enrico Carlo, 26016 Spino d'Adda (Cremona) (IT); TORTI, Cesare, 27100 Pavia (IT); MANFRE', Davide, 26025 Pandino (Cremona) (IT); CARUSO, Massimo, 98122 Messina (IT); PERRONI, Maurizio Francesco, 98054 Furnari (Messina) (IT)
(74) Representative: Buzzi, Notaro & Antonielli d'Oulx S.p.A.

(56) References cited:
- US-A1- 2021 183 442

## Description

### Technical field

The description relates to row decoder circuits and corresponding methods of operation.

Row decoders may be applied to non-volatile memories (NVM) where the state of a memory cell can be changed applying a programming current to the cell itself, such as phase-change memories (PCM), spin-torque magnetoresistive random-access memories (ST-MRAM), and resistive random-access memories (RRAM).

### Technological background

Document US 11289158 B2, assigned to companies of the STMicroelectronics group, discloses a non-volatile memory device that includes a row decoder. The row decoder includes a pull-down stage (e.g., operating as a NAND gate) and a pull-up stage (e.g., a p-channel transistor) for each word line of the memory. The pull-down stage is configured to tie the word line to ground (i.e., to select the word line) and the pull-up stage is configured to tie the word line to a selectable supply voltage (e.g., the supply voltage being 2 V during read operation and 4.8 V during write operation). The row decoder further includes a CMOS inverter configured to drive the pull-up stage. The CMOS inverter is supplied between the supply voltage and a selectable shifted ground voltage (e.g., the shifted ground voltage being 0 V during read operation and 2.4 V during write operation). The input node of the CMOS inverter is biased by a current generator (e.g., a current mirror) and can be tied to ground via one or more selection transistors coupled in series with two cascode n-channel transistors. During read operation, the input node of the CMOS inverter switches between 0 V (selected word line) and 1.8 V (unselected word line). During write operation, the input node of the CMOS inverter switches between 0 V (selected word line) and 4.8 V (unselected word line). Therefore, transistors in the CMOS inverter and in the current generator are dimensioned for 5 V rating.

Other documents possibly of interest in the field of the invention include US 2014/0269140 A1, US 2023/0062498 A1, US 2016/0240260 A1, and US 6885250 B1.

In such known memory applications, the voltage domain of the row decoder circuit may be between ground voltage (e.g., 0 V) and a relatively high voltage (e.g., 4.8 V or 5 V, the higher value of the selectable supply voltage), and the transistors are conventionally designed (e.g., sized) for such a voltage rating. Such sizing implies thick gate oxide and/or large area occupation, and the fabrication of such high-voltage transistors also requires dedicated manufacturing steps and dedicated masks that make the manufacturing costs increase.

Therefore, there is a need in the art to provide improved row decoder circuits that do not rely on high-voltage rating transistors.

### Object and summary

An object of one or more embodiments is to contribute in providing such improved row decoder circuits that can handle high voltages (e.g., in the range of 0 V to about 5 V) without implementing high-voltage rating transistors, but implementing (only) low-voltage rating transistors (e.g., in the range of 0 V to about 2.5 V).

According to one or more embodiments, such an object can be achieved by a memory device having the features set forth in the claims that follow.

One or more embodiments may relate to a corresponding method of operation.

The claims are an integral part of the technical teaching provided herein in respect of the embodiments.

According to an aspect of the present description, a memory device includes a row decoder circuit. The row decoder circuit includes at least one input node configured to receive at least one row selection signal and an output node configured for coupling to a word line of a memory device. The row decoder includes a pull-down circuit coupled between the word line and a ground node at ground voltage. The pull-down circuit is configured to selectively couple the word line to the ground node in response to the at least one row selection signal being asserted. The row decoder includes a pull-up circuit coupled between the word line and a supply node that provides a selectable supply voltage. The pull-up circuit is configured to selectively couple the word line to the supply node in response to a deselection signal being de-asserted. The row decoder includes an inverter circuit supplied between the supply node and a shifted ground node that provides a selectable reference voltage. The inverter circuit is configured to receive as input a control signal from a control node and produce the deselection signal. The row decoder includes a current generator circuit configured to source a biasing current to the control node. The row decoder includes a further pull-down circuit coupled between the control node and the ground node. The further pull-down circuit is configured to selectively couple the control node to the ground node in response to the at least one row selection signal being asserted. The further pull-down circuit includes a first cascode n-channel transistor, a cascode p-channel transistor, a second cascode **n-**channel transistor, and at least one selection transistor having their conductive channels arranged in series between the control node and the ground node. The at least one selection transistor is controlled by the at least one row selection signal. The first cascode n-channel transistor has a conductive channel arranged between the control node and a first cascode node. The cascode p-channel transistor has a conductive channel arranged between the first cascode node and a second cascode node. The second cascode n-channel transistor has a conductive channel arranged between the second cascode node and a third cascode node. The at least one selection transistor has a conductive channel arranged between the third cascode node and the ground node. The cascode p-channel transistor has a control terminal configured to receive a cascode control voltage. The memory device comprises a memory control circuit configured to set the cascode control voltage to a negative value during read operation of the memory device.

One or more embodiments may thus provide a row decoder circuit able to manage high voltages (e.g., in the range of 0 V to 5 V) without resorting to high-voltage rating devices but using (only) low-voltage rating devices (e.g., in the range of 0 V to 2.5 V).

According to another aspect of the present description, a method of operating a memory device according to one or more embodiments includes:
- receiving at least one row selection signal at at least one input node of the row decoder;
- selectively coupling a word line to a ground node of the row decoder, via a pull-down circuit, in response to the at least one row selection signal being asserted;
- selectively coupling the word line to a supply node of the row decoder, via a pull-up circuit, in response to a deselection signal being de-asserted;
- receiving, at an input of an inverter circuit of the row decoder, a control signal from a control node of the row decoder and producing, at an output of the inverter circuit, the deselection signal;
- sourcing a biasing current to the control node via a current generator circuit;
- selectively coupling the control node to the ground node, via a further pull-down circuit, in response to the at least one row selection signal being asserted;
- receiving a cascode control voltage at the control terminal of a cascode p-channel transistor; and
- setting the cascode control voltage to a negative value during read operation of the memory device, via a memory control circuit of the memory device.

### Brief description of the drawings

One or more embodiments will now be described, by way of example, with reference to the annexed figures, wherein:
- Figure 1 is a circuit block diagram exemplary of a row decoder circuit;
- Figure 2 is a simplified circuit block diagram exemplary of the row decoder circuit of Figure 1; and
- Figure 3 is a circuit block diagram exemplary of a row decoder circuit according to one or more embodiments of the present description.

### Detailed description of exemplary embodiments

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is included in at least one embodiment. Hence, phrases such as "in an embodiment" or "in one embodiment" that may be present in one or more points of the present description do not necessarily refer to one and the same embodiment. Moreover, particular configurations, structures, or characteristics may be combined in any adequate way in one or more embodiments.

The headings/references used herein are provided merely for convenience and hence do not define the extent of protection or the scope of the embodiments.

Throughout the figures annexed herein, unless the context indicates otherwise, like parts or elements are indicated with like references/numerals and a corresponding description will not be repeated for the sake of brevity.

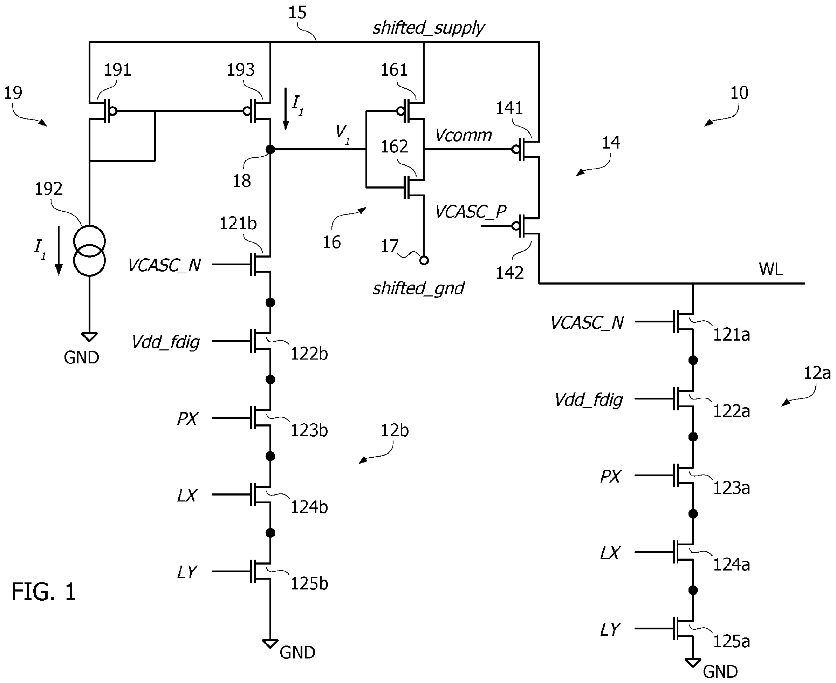

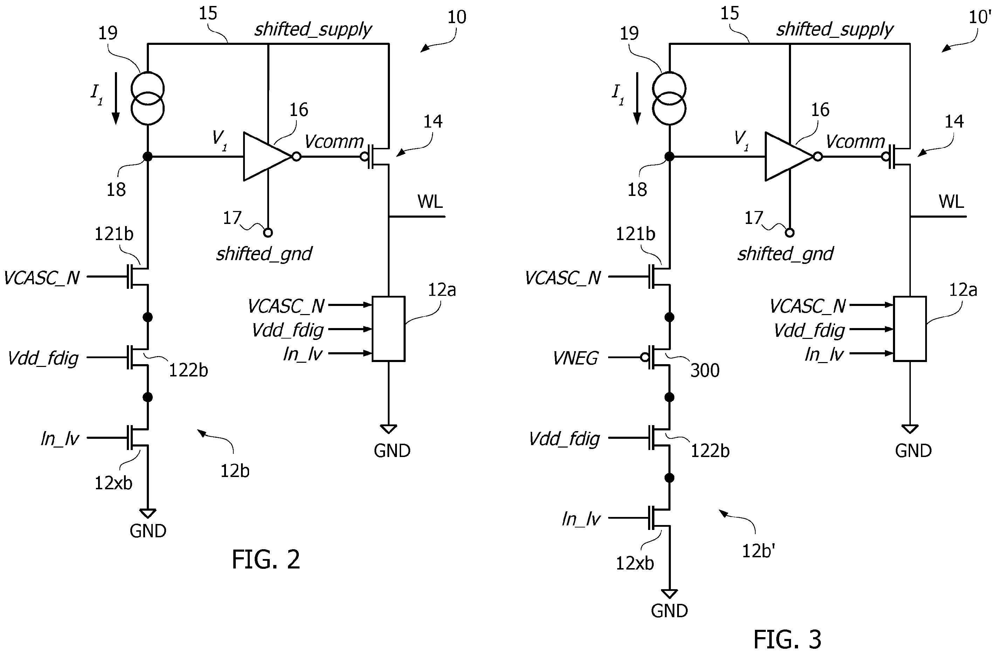

By way of introduction to the detailed description of exemplary embodiments, reference may be made to Figures 1 and 2, discussed in the following.

Figure 1 is a circuit block diagram exemplary of a row decoder circuit 10 as is known, for instance, from document US 11289158 B2 cited in the foregoing. The row decoder circuit 10 is configured to control (i.e., select and deselect) a word line WL of a memory device. To this effect, the row decoder 10 includes a pull-down stage 12a and a pull-up stage 14 for each word line WL of the memory. The pull-down stage 12a is configured to tie the word line WL to ground GND (i.e., to select the word line) and the pull-up stage 14 is configured to tie the word line WL to a supply node 15 that provides a selectable (or variable) supply voltage *shifted_supply* (i.e., to deselect the word line). The supply voltage *shifted_supply* may be, for instance, 2 V during read operation and 4.8 V during write operation.

The pull-down stage 12a may include five n-channel MOS transistors arranged in series between the word line WL and ground GND, and specifically, starting from the word line WL and moving towards ground GND: a first cascode transistor 121a, a second cascode transistor 122a, a first selection transistor 123a, a second selection transistor 124a, and a third selection transistor 125a. Transistor 121a has a drain terminal coupled to the word line WL, a gate terminal configured to receive a first (positive) cascode voltage *VCASC_N,* and a source terminal coupled to the drain terminal of transistor 122a. Transistor 122a has a drain terminal coupled to the source terminal of transistor 121a, a gate terminal configured to receive a second (positive) cascode voltage *Vdd*_*fdig*, and a source terminal coupled to the drain terminal of transistor 123a. Transistor 123a has a drain terminal coupled to the source terminal of transistor 122a, a gate terminal configured to receive a first selection signal *PX,* and a source terminal coupled to the drain terminal of transistor 124a. Transistor 124a has a drain terminal coupled to the source terminal of transistor 123a, a gate terminal configured to receive a second selection signal *LX,* and a source terminal coupled to the drain terminal of transistor 125a. Transistor 125a has a drain terminal coupled to the source terminal of transistor 124a, a gate terminal configured to receive a third selection signal *LY,* and a source terminal coupled to ground GND.

The pull-up stage 14 may include two p-channel MOS transistors arranged in series between the supply node 15 and the word line WL, and specifically, starting from the supply node 15 and moving towards the word line WL: a deselection transistor 141, and a cascode transistor 142. Transistor 141 has a source terminal coupled to the supply node 15, a gate terminal configured to receive a deselection signal *Vcomm,* and a drain terminal coupled to the source terminal of transistor 142. Transistor 142 has a source terminal coupled to the drain terminal of transistor 141, a gate terminal configured to receive a cascode voltage *VCASC_P,* and a drain terminal coupled to the word line WL.

The row decoder 10 further includes a CMOS inverter 16 configured to produce signal *Vcomm* to drive transistor 141. The CMOS inverter 16 is supplied between node 15 (at voltage *shifted_supply*) and a shifted ground node 17 that provides a selectable (or variable) shifted ground voltage *shifted_gnd.* The shifted ground voltage *shifted_gnd* may be, for instance, 0 V during read operation and 2.4 V during write operation (i.e., equal to the reference voltage of ground GND during read operation, and equal to half of the supply voltage *shifted_supply* during write operation). In particular, inverter 16 may include a p-channel MOS transistor 161 and an n-channel MOS transistor 162 arranged in series between nodes 15 and 17. Transistor 161 has a source terminal coupled to the supply node 15, a gate terminal coupled to a deselection control node 18, and a drain terminal coupled to the drain terminal of transistor 162 and to the gate terminal of transistor 141. Transistor 162 has a drain terminal coupled to the drain terminal of transistor 161 and to the gate terminal of transistor 141, a gate terminal coupled to node 18, and a source terminal coupled to the shifted ground node 17.

The deselection control node 18 (i.e., the input of the CMOS inverter 16) is biased by a current generator 19 (e.g., a current mirror) that sources a current *I₁* to it. For instance, the current mirror 19 may include a first branch including a diode-connected p-channel MOS transistor 191 arranged in series with a current-sinking element 192 between the supply node 15 and ground GND, and a second branch including a mirroring p-channel MOS transistor 193 arranged between the supply node 15 and the control node 18 and having a gate terminal coupled to the gate terminal of transistor 191 to source current *I₁* to node 18. The mirroring ratio of transistors 191 and 193 may be unitary.

The deselection control node 18 can be tied to ground GND via a pull-down stage 12b that replicates the structure and operation of the pull-down stage 12a. In particular, the pull-down stage 12b includes two cascode n-channel transistors 121b, 122b coupled in series with a plurality of (e.g., three) selection transistors 123b, 124b, 125b that receive the same signals *VCASC_N, Vdd_fdig, PX, LX, LY* as the pull-down stage 12a.

Therefore, a switching control voltage *V₁* is produced at node 18 by the operation of the generator 19 and the pull-down stage 12b.

Figure 2 shows the same architecture of Figure 1 in a simplified view, where the internal structure of the pull-down stage 12a, the pull-up stage 14, the CMOS inverter 16 and the current generator 19 is not shown in detail. Further, concerning the pull-down stage 12b, the selection transistors 123b, 124b and 125b are shown as a single transistor 12xb and the reference *ln_lv* is used to indicate collectively the selection signals *PX, LX, LY.*

During read operation, voltage *V₁* at node 18 switches between 0 V (in case the word line WL is selected) and 1.8 V (in case the word line WL is deselected). During write operation, voltage *V₁* at node 18 switches between 0 V (in case the word line WL is selected) and 4.8 V (in case the word line WL is deselected). Therefore, transistors 161, 162 and 193 are subject to a 5 V (or 4.8 V) voltage swing, and are dimensioned accordingly (e.g., for 5 V rating). Such sizing may imply thick gate oxide and/or large area occupation, and the fabrication of such high-voltage transistors may also require dedicated manufacturing steps and dedicated masks that make the manufacturing costs increase.

Therefore, one or more embodiments relate to an improved row decoder circuit that does not rely on high-voltage rating transistors.

In detail, Figure 3 is a circuit block diagram exemplary of a row decoder circuit 10' according to one or more embodiments. As exemplified in Figure 3, the row decoder 10' includes substantially all the circuit components described with reference to the decoder architecture of Figures 1 and 2, plus an additional p-channel MOS cascode transistor 300 arranged in series with the cascode transistors 121b and 122b in the pull-down stage 12b' (i.e., between node 18 and ground GND). Transistor 300 is configured to receive, at its gate terminal, a cascode voltage *VNEG.*

The cascode transistor 300 is arranged between transistors 121b and 122b. In detail, transistor 300 has a source terminal coupled to the source terminal of transistor 121b, a drain terminal coupled to the drain terminal of transistor 122b, and a gate terminal configured to receive the cascode voltage *VNEG.*

The cascode voltage *VNEG* is produced by a control circuit of the memory device. In one or more embodiments, the cascode voltage *VNEG* may be, for instance, 0 V minus a threshold Vth during read operation (i.e., the ground voltage GND minus the threshold Vth) and 2.4 V minus the threshold Vth during write operation (i.e., half of the supply voltage *shifted_supply* minus the threshold Vth). For instance, the threshold Vth (the voltage threshold of transistor 300) may be equal to 0.4 V. In this example, the cascode voltage *VNEG* is equal to -0.4 V during read operation and equal to 2.0 V during write operation. Therefore, at least during read operation, the cascode voltage *VNEG* is negative.

Therefore, in the architecture of Figure 3, the voltages may assume the following exemplary values, depending on whether the memory operates in read mode or write mode, and depending on whether the word line WL has to be selected or deselected. During read operation, to select the word line WL, the selection signals *ln_lv* (e.g., *PX, LX, PY*) are logic high (e.g., 1 V), the cascode voltage *VNEG* is negative (e.g., -0.4 V), the supply voltage *shifted_supply* is 2 V, and the ground voltage *shifted_gnd* is 0 V; consequently, voltage *V₁* at node 18 is 0 V, voltage *Vcomm* is 2 V, and the word line WL is pulled down to ground GND (0 V). During read operation, to deselect the word line WL, the selection signals *ln_lv* (e.g., *PX, LX, PY*) are logic low (e.g., 0 V), the cascode voltage *VNEG* is negative (e.g., - 0.4 V), the supply voltage *shifted_supply* is 2 V, and the ground voltage *shifted_gnd* is 0 V; consequently, voltage *V₁* at node 18 is 2 V, voltage *Vcomm* is 0 V, and the word line WL is pulled up to the supply voltage *shifted_supply* (2 V). During write operation, to select the word line WL, the selection signals *ln_lv* (e.g., *PX, LX, PY*) are logic high (e.g., 1 V), the cascode voltage *VNEG* is positive (e.g., 2 V), the supply voltage *shifted_supply* is 4.8 V, and the ground voltage *shifted_gnd* is 2.4 V; consequently, voltage *V₁* at node 18 is 2.4 V, voltage *Vcomm* is 4.8 V, and the word line WL is pulled down to ground GND (0 V). During write operation, to deselect the word line WL, the selection signals *ln_lv* (e.g., *PX, LX, PY*) are logic low (e.g., 0 V), the cascode voltage *VNEG* is positive (e.g., 2 V), the supply voltage *shifted_supply* is 4.8 V, and the ground voltage *shifted_gnd* is 2.4 V; consequently, voltage *V₁* at node 18 is 4.8 V, voltage *Vcomm* is 2.4 V, and the word line WL is pulled up to the supply voltage *shifted_supply* (4.8 V).

Therefore, in the architecture of Figure 3, voltage *V₁* at node 18 switches between 0 V (in case the word line WL is selected) and 1.8 V (in case the word line WL is deselected) during read operation, and it switches between 2.4 V (in case the word line WL is selected) and 4.8 V (in case the word line WL is deselected) during write operation. Therefore, the voltage swing of node 18 is limited to less than 2.5 V. As a result, transistors 161, 162 and 193 are subject to a maximum voltage swing of 2.5 V, and are dimensioned accordingly (e.g., for 2.5 V rating). Such sizing implies a thinner gate oxide, a lower area occupation and /or a higher switching speed compared to previous solutions. Further, the fabrication of low-voltage transistors implies less manufacturing steps and less masks compared to previous solutions, which result in lower manufacturing costs.

As anticipated, row decoder circuits as disclosed herein may be used in the control circuits of a memory.

One or more embodiments as exemplified herein may thus be advantageous insofar as they facilitate managing "high" voltages (e.g., in the range of 0 V to 5 V) without resorting to high-voltage rating devices but using (only) low-voltage rating devices (e.g., in the range of 0 V to 2.5 V).

Without prejudice to the underlying principles, the details and embodiments may vary, even significantly, with respect to what has been described by way of example, without departing from the extent of protection.

The extent of protection is determined by the annexed claims.

## Claims

1. Memory device comprising a row decoder circuit (10'), the row decoder circuit (10') comprising:
at least one input node configured to receive at least one row selection signal (*PX, LX, LY; ln_lv*) and an output node configured for coupling to a word line (WL) of the memory device;
a pull-down circuit (121a, 122a, 123a, 124a, 125a; 12a) coupled between said word line (WL) and a ground node (GND) at ground voltage, the pull-down circuit (12a) being configured to selectively couple the word line (WL) to the ground node (GND) in response to said at least one row selection signal (*ln_lv*) being asserted;
a pull-up circuit (141, 142; 14) coupled between said word line (WL) and a supply node (15) that provides a selectable supply voltage (*shifted_supply),* the pull-up circuit (15) being configured to selectively couple the word line (WL) to the supply node (15) in response to a deselection signal (*Vcomm*) being de-asserted;
an inverter circuit (161, 162; 16) supplied between said supply node (15) and a shifted ground node (17) that provides a selectable reference voltage (*shifted*_*gnd*), the inverter circuit (16) being configured to receive as input a control signal (*V₁*) from a control node (18) and produce said deselection signal (*Vcomm*) ;
a current generator circuit (191, 192, 193; 19) configured to source a biasing current (*I₁*) to said control node (18); and
a further pull-down circuit (121b, 122b, 123b, 124b, 125b, 300; 12b') coupled between said control node (18) and the ground node (GND), the further pull-down circuit (12b') being configured to selectively couple the control node (18) to the ground node (GND) in response to said at least one row selection signal (*ln_lv*) being asserted;
wherein the further pull-down circuit (12b') comprises a first cascode n-channel transistor (121b), a cascode p-channel transistor (300), a second cascode n-channel transistor (122b), and at least one selection transistor (123b, 124b, 125b; 12xb) having their conductive channels arranged in series between said control node (18) and the ground node (GND), wherein the at least one selection transistor (12xb) is controlled by said at least one row selection signal (*ln_lv*);
wherein:
said first cascode n-channel transistor (121b) has a conductive channel arranged between said control node (18) and a first cascode node;
said cascode p-channel transistor (300) has a conductive channel arranged between said first cascode node and a second cascode node;
said second cascode n-channel transistor (122b) has a conductive channel arranged between said second cascode node and a third cascode node; and
said at least one selection transistor (123b, 124b, 125b; 12xb) has a conductive channel arranged between said third cascode node and the ground node (GND);
wherein said cascode p-channel transistor (300) has a control terminal configured to receive a cascode control voltage (*VNEG*);
and wherein the memory device comprises a memory control circuit configured to set said cascode control voltage *(VNEG)* to a negative value during read operation of said memory device.

2. Memory device according to claim 1, wherein said negative value of the cascode control voltage *(VNEG)* is equal to ground voltage minus a threshold, said threshold being preferably in the range of 0.3 V to 0.5 V, more preferably equal to 0.4 V.

3. Memory device according to any of the previous claims, wherein the memory control circuit is configured to set said cascode control voltage *(VNEG)* to a positive value during write operation of said memory device.

4. Memory device according to claim 3, wherein said positive value of the cascode control voltage *(VNEG)* is equal to half of said selectable supply voltage (*shifted_supply*) minus a threshold, said threshold being preferably in the range of 0.3 V to 0.5 V, more preferably equal to 0.4 V.

5. Memory device according to any of the previous claims, wherein the memory control circuit is configured to:
during read operation of said memory device, set said selectable supply voltage (*shifted_supply*) to a first supply value and set said selectable reference voltage (*shifted_gnd*) to said ground voltage; and
during write operation of said memory device, set said selectable supply voltage (*shifted_supply*) to a second supply value, the second supply value being higher than the first supply value, and set said selectable reference voltage (*shifted_gnd*) to half of said second supply value.

6. Memory device according to claim 5, wherein said first supply value is equal to 2 V and said second supply value is equal to 4.8 V.

7. A method of operating a memory device according to any of the previous claims, the method comprising:
receiving at least one row selection signal (*PX*, *LX, LY; ln_lv*) at said at least one input node;
selectively coupling said word line (WL) to said ground node (GND), via said pull-down circuit (121a, 122a, 123a, 124a, 125a; 12a), in response to said at least one row selection signal (*ln_lv*) being asserted;
selectively coupling said word line (WL) to said supply node (15), via said pull-up circuit (141, 142; 14), in response to a deselection signal (*Vcomm*) being de-asserted;
receiving, at an input of said inverter circuit (16), a control signal (*V₁*) from a control node (18) and producing, at an output of said inverter circuit (16), said deselection signal (*Vcomm*);
sourcing a biasing current (*I₁*) to said control node (18) via said current generator circuit (191, 192, 193; 19) ;
selectively coupling the control node (18) to the ground node (GND), via said further pull-down circuit (121b, 122b, 123b, 124b, 125b, 300; 12b'), in response to said at least one row selection signal (*ln_lv*) being asserted;
receiving a cascode control voltage *(VNEG)* at said control terminal of said cascode p-channel transistor (300); and
setting said cascode control voltage *(VNEG)* to a negative value during read operation of said memory device, via said memory control circuit.

## Patentansprüche

1. Speichervorrichtung, umfassend eine Zeilendecoderschaltung (10'), wobei die Zeilendecoderschaltung (10') umfasst:
mindestens einen Eingangsknoten, der konfiguriert ist, um mindestens ein Zeilenauswahlsignal (*PX*, *LX*, *LY*; *ln_lv*) zu empfangen, und einen Ausgangsknoten, der zum Koppeln mit einer Wortleitung (WL) der Speichervorrichtung konfiguriert ist;
eine Pull-Down-Schaltung (121a, 122a, 123a, 124a, 125a; 12a), die zwischen der Wortleitung (WL) und einem Erdungsknoten (GND) bei Erdungsspannung gekoppelt ist, wobei die Pull-Down-Schaltung (12a) konfiguriert ist, um die Wortleitung (WL) als Reaktion darauf, dass das mindestens eine Zeilenauswahlsignal (*ln_lv*) anliegt, selektiv mit dem Erdungsknoten (GND) zu koppeln;
eine Pull-up-Schaltung (141, 142; 14), die zwischen der Wortleitung (WL) und einem Versorgungsknoten (15) gekoppelt ist, der eine wählbare Versorgungsspannung (*shifted_supply*) bereitstellt, wobei die Pull-up-Schaltung (15) konfiguriert ist, um die Wortleitung (WL) als Reaktion darauf, dass ein Abwahlsignal (*Vcomm*) aufgehoben wird, selektiv mit dem Versorgungsknoten (15) zu koppeln;
eine Wechselrichterschaltung (161, 162; 16), die zwischen dem Versorgungsknoten (15) und einem verschobenen Erdungsknoten (17) versorgt wird, der eine wählbare Referenzspannung (*shifted_gnd*) bereitstellt, wobei die Wechselrichterschaltung (16) konfiguriert ist, um als Eingang ein Steuersignal (*V₁*) von einem Steuerknoten (18) zu empfangen und das Abwahlsignal (*Vcomm*) zu erzeugen;
eine Stromgeneratorschaltung (191, 192, 193; 19), die konfiguriert ist, um einen Vorspannungsstrom (*I₁*) für den Steuerknoten (18) zu beschaffen; und
eine weitere Pull-Down-Schaltung (121b, 122b, 123b, 124b, 125b, 300; 12b'), die zwischen dem Steuerknoten (18) und dem Erdungsknoten (GND) gekoppelt ist, wobei die weitere Pull-Down-Schaltung (12b') konfiguriert ist, um den Steuerknoten (18) als Reaktion darauf, dass das mindestens eine Zeilenauswahlsignal (*ln_lv*) anliegt, selektiv mit dem Erdungsknoten (GND) zu koppeln;
wobei die weitere Pull-Down-Schaltung (12b') einen ersten Kaskoden-N-Kanal-Transistor (121b), einen Kaskoden-P-Kanal-Transistor (300), einen zweiten Kaskoden-N-Kanal-Transistor (122b) und mindestens einen Auswahltransistor (123b, 124b, 125b; 12xb) umfasst, deren leitfähige Kanäle in Reihe zwischen dem Steuerknoten (18) und dem Erdungsknoten (GND) angeordnet sind, wobei der mindestens eine Auswahltransistor (12xb) durch das mindestens eine Zeilenauswahlsignal (*ln_lv*) gesteuert wird;
wobei:
der erste Kaskoden-N-Kanal-Transistor (121b) einen leitfähigen Kanal aufweist, der zwischen dem Steuerknoten (18) und einem ersten Kaskoden-Knoten angeordnet ist;
der Kaskoden-P-Kanal-Transistor (300) einen leitfähigen Kanal aufweist, der zwischen dem ersten Kaskoden-Knoten und einem zweiten Kaskoden-Knoten angeordnet ist;
der zweite Kaskoden-N-Kanal-Transistor (122b) einen leitfähigen Kanal aufweist, der zwischen dem zweiten Kaskoden-Knoten und einem dritten Kaskoden-Knoten angeordnet ist; und
der mindestens eine Auswahltransistor (123b, 124b, 125b; 12xb) einen leitfähigen Kanal aufweist, der zwischen dem dritten Kaskoden-Knoten und dem Erdungsknoten (GND) angeordnet ist;
wobei der Kaskoden-P-Kanal-Transistor (300) einen Steueranschluss aufweist, der konfiguriert ist, um eine Kaskoden-Steuerspannung (*VNEG*) zu empfangen;
und wobei die Speichervorrichtung eine Speichersteuerschaltung umfasst, die konfiguriert ist, um die Kaskoden-Steuerspannung (*VNEG*) während eines Lesebetriebs der Speichervorrichtung auf einen negativen Wert zu setzen.

2. Speichervorrichtung nach Anspruch 1, wobei der negative Wert der Kaskoden-Steuerspannung (*VNEG*) gleich der Erdungsspannung minus einer Schwelle ist, wobei die Schwelle vorzugsweise im Bereich von 0,3 V bis 0,5 V liegt, bevorzugter gleich 0,4 V ist.

3. Speichervorrichtung nach einem der vorstehenden Ansprüche, wobei die Speichersteuerschaltung konfiguriert ist, um die Kaskoden-Steuerspannung (*VNEG*) während eines Schreibbetriebs der Speichervorrichtung auf einen positiven Wert zu setzen.

4. Speichervorrichtung nach Anspruch 3, wobei der positive Wert der Kaskoden-Steuerspannung (*VNEG*) gleich der Hälfte der wählbaren Versorgungsspannung (*shifted_supply*) abzüglich einer Schwelle ist, wobei die Schwelle vorzugsweise im Bereich von 0,3 V bis 0,5 V liegt, bevorzugter gleich 0,4 V ist.

5. Speichervorrichtung nach einem der vorstehenden Ansprüche, wobei die Speichersteuerschaltung konfiguriert ist, um:
während eines Lesebetriebs der Speichervorrichtung die wählbare Versorgungsspannung (*shifted_supply*) auf einen ersten Versorgungswert zu setzen und die wählbare Referenzspannung (*shifted_gnd*) auf die Erdungsspannung zu setzen; und
während eines Schreibbetriebs der Speichervorrichtung die wählbare Versorgungsspannung (*shifted_supply*) auf einen zweiten Versorgungswert zu setzen, wobei der zweite Versorgungswert höher als der erste Versorgungswert ist, und die wählbare Referenzspannung (*shifted_gnd*) auf die Hälfte des zweiten Versorgungswerts zu setzen.

6. Speichervorrichtung nach Anspruch 5, wobei der erste Versorgungswert gleich 2 V ist und der zweite Versorgungswert gleich 4,8 V ist.

7. Verfahren zum Betreiben einer Speichervorrichtung nach einem der vorstehenden Ansprüche, wobei das Verfahren umfasst:
Empfangen mindestens eines Zeilenauswahlsignals (*PX*, *LX*, *LY*; *ln_lv*) an dem mindestens einen Eingangsknoten;
selektives Koppeln der Wortleitung (WL) an den Erdungsknoten (GND), über die Pull-Down-Schaltung (121a, 122a, 123a, 124a, 125a; 12a), als Reaktion darauf, dass das mindestens eine Zeilenauswahlsignal (*ln_lv*) anliegt;
selektives Koppeln der Wortleitung (WL) an den Versorgungsknoten (15), über die Pull-up-Schaltung (141, 142; 14), als Reaktion darauf, dass ein Abwahlsignal (*Vcomm*) aufgehoben wird;
Empfangen eines Steuersignals (V₁) von einem Steuerknoten (18) an einem Eingang der Wechselrichterschaltung (16) und Erzeugen des Abwahlsignals (*Vcomm*) an einem Ausgang der Wechselrichterschaltung (16);
Beschaffen eines Vorspannungsstroms (*I₁*) für den Steuerknoten (18) über die Stromgeneratorschaltung (191, 192, 193; 19);
selektives Koppeln des Steuerknotens (18) an den Erdungsknoten (GND), über die weitere Pull-Down-Schaltung (121b, 122b, 123b, 124b, 125b, 300; 12b'), als Reaktion darauf, dass das Zeilenauswahlsignal (*ln_lv*) anliegt;
Empfangen einer Kaskoden-Steuerspannung (*VNEG*) am Steueranschluss des Kaskoden-P-Kanal-Transistors (300); und
Setzen der Kaskoden-Steuerspannung (*VNEG*) auf einen negativen Wert während eines Lesebetriebs der Speichervorrichtung über die Speichersteuerschaltung.

## Revendications

1. Dispositif de mémoire comprenant un circuit décodeur de rangée (10'), le circuit décodeur de rangée (10') comprenant :
au moins un nœud d'entrée configuré pour recevoir au moins un signal de sélection de rangée (PX, LX, LY; ln_lv) et un nœud de sortie configuré pour couplage à une ligne de mots (WL) du dispositif de mémoire ;
un circuit d'excursion basse (121a, 122a, 123a, 124a, 125a; 12a) couplé entre ladite ligne de mots (WL) et un nœud de terre (GND) à la tension de la terre, le circuit d'excursion basse (12a) étant configuré pour coupler sélectivement la ligne de mots (WL) au nœud de terre (GND) en réponse audit au moins un signal de sélection de rangée (ln_lv) étant activé ;
un circuit d'excursion haute (141, 142; 14) couplé entre ladite ligne de mots (WL) et un nœud d'alimentation (15) qui fournit une tension d'alimentation sélectionnable (shifted_supply), circuit d'excursion haute (15) étant configuré pour coupler sélectivement la ligne de mots (WL) au nœud d'alimentation (15) en réponse à un signal de désélection (Vcomm) étant désactivé ;
un circuit inverseur (161, 162; 16) placé entre ledit nœud d'alimentation (15) et un nœud de terre décalé (17) qui fournit une tension de référence sélectionnable (shifted_gnd), le circuit inverseur (16) étant configuré pour recevoir comme entrée un signal de commande (Vi) depuis un nœud de commande (18) et produire ledit signal de désélection (Vcomm) ;
un circuit générateur de courant (191, 192, 193; 19) configuré pour sourcer un courant de polarisation (Ii) audit nœud de commande (18) ; et
un autre circuit d'excursion basse (121b, 122b, 123b, 124b, 125b, 300; 12b') couplé entre ledit nœud de commande (18) et le nœud de terre (GND), l'autre circuit d'excursion basse (12b') étant configuré pour coupler sélectivement le nœud de commande (18) au nœud de terre (GND) en réponse à ledit au moins un signal de sélection de rangée (ln_lv) étant activé;
dans lequel l'autre circuit d'excursion basse (12b') comprend un premier transistor à canal n monté en cascode (121b), un transistor à canal p monté en cascode (300), un second transistor à canal n monté en cascode (122b), et au moins un transistor de sélection (123b, 124b, 125b; 12xb) ayant leurs canaux conducteurs agencés en série entre ledit nœud de commande (18) et le nœud de terre (GND), dans lequel l'au moins un transistor de sélection (12xb) est commandé par ledit au moins un signal de sélection de rangée (ln_lv) ;
dans lequel :
ledit premier transistor à canal n monté en cascode (121b) a un canal conducteur agencé entre ledit nœud de commande (18) et un premier nœud de cascode ;
ledit un transistor à canal p monté en cascode (300) a un canal conducteur agencé entre ledit premier nœud de cascode et un second nœud de cascode ;
ledit second transistor à canal n monté en cascode (122b) a un canal conducteur agencé entre ledit second nœud de cascode et un troisième nœud de cascode ; et
ledit au moins un transistor de sélection (123b, 124b, 125b; 12xb) a un canal conducteur agencé entre ledit troisième nœud de cascode et le nœud de terre (GND) ;
dans lequel ledit un transistor à canal p monté en cascode (300) a une borne de commande configurée pour recevoir une tension de commande de cascode (VNEG) ;
et dans lequel le dispositif de mémoire comprend un circuit de commande de mémoire configuré pour régler ladite tension de commande de cascode (VNEG) à une valeur négative pendant une opération de lecture dudit dispositif de mémoire.

2. Dispositif de mémoire selon la revendication 1, dans lequel ladite valeur négative de la tension de commande de cascode (VNEG) est égale à la tension de terre moins un seuil, ledit seuil étant de préférence dans la plage de 0,3 V à 0,5 V, plus préférablement égal à 0,4 V.

3. Dispositif de mémoire selon l'une quelconque des revendications précédentes, dans lequel le circuit de commande de mémoire est configuré pour régler ladite tension de commande de cascode (VNEG) à une valeur positive pendant l'opération d'écriture dudit dispositif de mémoire.

4. Dispositif de mémoire selon la revendication 3, dans lequel ladite valeur positive de la tension de commande de cascode (VNEG) est égale à la moitié de ladite tension d'alimentation sélectionnable (shifted_supply) moins un seuil, ledit seuil étant de préférence dans la plage de 0,3 V à 0,5 V, plus préférablement égal à 0,4 V.

5. Dispositif de mémoire selon l'une quelconque des revendications précédentes, dans lequel le circuit de commande de mémoire est configuré pour :
pendant l'opération de lecture dudit dispositif de mémoire tension d'alimentation sélectionnable (shifted_supply) à une première valeur d'alimentation et régler ladite tension de référence sélectionnable (shifted_gnd) à ladite tension de terre ; et
pendant l'opération d'écriture dudit dispositif de mémoire, régler ladite tension d'alimentation sélectionnable (shifted_supply) à une seconde valeur d'alimentation, la seconde valeur d'alimentation étant supérieure à la première valeur d'alimentation, et régler ladite tension de référence sélectionnable (shifted_gnd) à la moitié de ladite seconde valeur d'alimentation.

6. Dispositif de mémoire selon la revendication 5, dans lequel ladite première valeur d'alimentation est égale à 2 V et ladite seconde valeur d'alimentation est égale à 4.0 V.

7. Procédé d'utilisation d'un dispositif de mémoire selon l'une quelconque des revendications précédentes, le procédé comprenant :
de recevoir au moins un signal de sélection de rangée (PX, LX, LY; ln_lv) au niveau dudit au moins un nœud d'entrée ;
de coupler sélectivement ladite ligne de mots (WL) audit nœud de terre (GND), via ledit circuit d'excursion basse (121a, 122a, 123a, 124a, 125a; 12a), en réponse audit au moins un signal de sélection de rangée (ln_lv) étant activé ;
de coupler sélectivement ladite ligne de mots (WL) audit nœud d'alimentation (15), via ledit circuit d'excursion haute (141, 142; 14), en réponse à un signal de désélection (Vcomm) étant désactivé ;
de recevoir, à une entrée dudit circuit inverseur (16), un signal de commande (Vi) depuis un nœud de commande (18) et de produire, à une sortie dudit circuit inverseur (16), ledit signal de désélection (Vcomm) ;
de sourcer un courant de polarisation (Ii) audit nœud de commande (18) via ledit circuit générateur de courant (191, 192, 193; 19) ;
de coupler sélectivement le nœud de commande (18) au nœud de terre (GND), via ledit autre circuit d'excursion basse (121b, 122b, 123b, 124b, 125b, 300; 12b'), en réponse audit au moins un signal de sélection de rangée (ln_lv) étant activé;
de recevoir une tension de commande de cascode (VNEG) au niveau de ladite borne de commande dudit transistor à canal p monté en cascode (300) ; et
de régler ladite tension de commande de cascode (VNEG) à une valeur négative pendant une opération de lecture dudit dispositif de mémoire, via ledit circuit de commande de mémoire.
